Europäisches Patentamt

(19) European Patent Office

Office européen des brevets

(11) EP 0 957 614 A1

## (12) EUROPEAN PATENT APPLICATION

(43) Date of publication:
17.11.1999 Bulletin 1999/46

(51) Int. Cl.$^6$: **H04L 27/227**, H04L 27/38

(21) Application number: 98108833.9

(22) Date of filing: 14.05.1998

(84) Designated Contracting States:
AT BE CH CY DE DK ES FI FR GB GR IE IT LI LU
MC NL PT SE
Designated Extension States:
AL LT LV MK RO SI

(71) Applicant:
Sony International (Europe) GmbH
50829 Köln (DE)

(72) Inventors:
• Krupezevic, Dragan, Dr.-Ing.
Stuttgarter Strasse 106, 70736 Fellbach (DE)
• Brankovic, Veselin, Dr.-Ing.
Stuttgarter Strasse 106, 70736 Fellbach (DE)

(74) Representative:
Rupp, Christian, Dipl.Phys. et al
Mitscherlich & Partner
Patent- und Rechtsanwälte
Sonnenstrasse 33
80331 München (DE)

### (54) N-port demodulator for PSK or QAM signals

(57) According to the present invention and method and the device for the I/Q demodulation of modulated RF signals is provided. The I/Q-demodulator thereby comprises a passive n-port junction device (f.e. a six-port or five-port junction device) (1), wherein a plurality of power detectors (P1, P2, P3, P(n-2)) are provided being supplied with analog signals output of the five-port or six-port junction device (1). An analog circuitry (2, 3) is supplied with signals output of the power detectors (P1, P2, P3, P(n-2)). The analog circuitry (2, 3) detects I/Q components of the signal to be demodulated based on an analog processing of the analog signals output of the power detectors (P1, P2, P3, P(n-2)). A local oscillator circuitry (20) is provided to supply a second input signal for the five-port or six-port junction device (1). Filters (4) are provided for filtering the analog signals output of the power detectors (P1, P2, P3, P(n-2) before they are supplied to the analog circuitry (2, 3). The analog circuitry (3) comprises circuits (7) to supply the analog signals output of the power detectors (P1, P2, P3) respectively in two branches. Furthermore amplifiers (8) with individually adjustable gain (g1, g2, g3, g4, g5, g6, g7, g8) are provided to amplify the branches. Finally an adding/subtracting circuitry 9, 10 is provided being supplied with the individually amplified branches to detect I/Q components of the RF signal to be demodulated (signal 1). A processing unit (19) is provided for calibrating the five-port or six-port junction device 1 by adjusting at least one of the adjustable gains (G1, G2, G3, G4; g1, g2, g3, g4, g5, g6, g7, g8).

Fig. 1

Printed by Xerox (UK) Business Services
2.16.7/3.6

**Description**

The present invention relates to a method and a device for the I/Q demodulation of modulated RF signals. The invention is particularly advantageous for PSK or (n)QAM modulated RF signals. The invention furthermore relates to a telecommunications device comprising such a demodulating device.

A six-port receiver is known acting in the direct conversion manner and allowing conversion from mm-wave range and microwave range directly to the base band. At the same time a classic I/Q-demodulation chip (digital or analog) can be avoided. By using suitable calibration procedures the influences of the non-ideal passive RF-components including manufacturing tolerances can be minimized. The six-port receiver detects the relative phase and relative magnitude of two incoming RF-signals. The circuitry of the six-port receiver is realized using only passive components in combination with diodes for the detection of the relative phase and the relative magnitude of the RF-signals. An important feature of six-port receivers is that fabrication tolerances can be calibrated, which inherently allows low-cost production.

In Bossisio, Wu "A six-port direct digital millimeter wave receiver", Digest of 1994 IEEE MTT Symposium, vol. 3, page 1659 - 1662, San Diego, May 1994, a structure for a six-port receiver is proposed.

The six-port technique has been known for its ability to accurately measure the scattering parameters, both amplitude and phase, of microwave networks. Instead of using heterodyne receivers a six-port receiver accomplishes direct measurements at microwave and mm-wave frequencies by extracting signals output of the power detectors at at least three and particularly four of the 6 ports. The imperfections of the hardware can be readily eliminated by an appropriate calibration procedure. Very accurate measurements can be made in a large dynamic range and wide frequency range, six-port junction receivers consist of passive microwave components such as directional couplers and power dividers as well as diode detectors. The circuit can be easily integrated as MHMIC or MMIC. The known receiver performs direct phase/amplitude demodulation at microwave and mm-wave frequencies.

By performing a calibration procedure the hardware imperfections such as phase error of the bridges, imbalance of the power detectors, etc. can be readily eliminated. This significantly eases the requirement of the hardware implementation and enables the six-port receiver to operate over a wide band up to mm-wave frequencies.

According to the above cited document of Bossisio et. al. a six-port receiver concept with power dividers and 90 degrees hybrid circuits realized in distributed technology is used. The application of that known structure lies mainly in the frequency bands above 10 GHz, however, it suffers from an insufficient band width of the operation due to the inherently frequency selective nature of the 90 degrees hybrid circuits.

From D. Maurin, Y.Xu, B.Huyart, K.Wu, M. Cuhaci, R. Bossisio "CPW Millimeter-Wave Six-Port Reflectometers using MHMIC and MMIC technologies", European Microwave Conference 1994, pp. 911-915, a wide-band topology for reflectometer used is known which is based on a distributing element approach featuring coplanar wave guide applications in the frequency range from 11 to 25 GHz.

From V. Bilik, et al. "A new extremely wideband lumped six-port reflectometer" European Microwave Conference 1991, pp. 1473-1477 and the idea of using Wheatstone Bridges and resistive structures for reflectometer applications is known.

From j:Li, G.Bossisio, K.Wu, "Dual tone Calibration of Six-Port Junction and its application to the six-port direct digital receiver", IEEE Transactions on Microwave Theory and Techniques, vol. 40, January 1996 a six-port reflectometer topology based on four 3dB hybrid circuits, power dividers and attenuators is known.

From US-A-5498969 an asymmetrical topology for a reflectometer structure featuring matched detectors and one unmatched detector is known.

From US-A-4521728 with the title "Method and six-port network for use in determining complex reflection coefficients of microwave networks" a reflectometer six-port topology is known comprising two different quadrate hybrids, phase shifter, two power dividers and one directional coupler for which the realization by a microstrip line technology is disclosed.

The six-port technology inherently has the disadvantage that the computational effort is large for example in comparison with classic approaches (super-heterodyne receivers).

From the European Patent Application 97 113 755.9 in the name of the same applicant a non-coherent six-port receiver is known. The attention is thereby particularly drawn to the calculation of signals output of the power detectors by linear combinations of two RF input signals as well as the calculation of the phase and the amplitude of a complex signal on the basis of four signals output of the power detectors, which is herewith incorporated by reference.

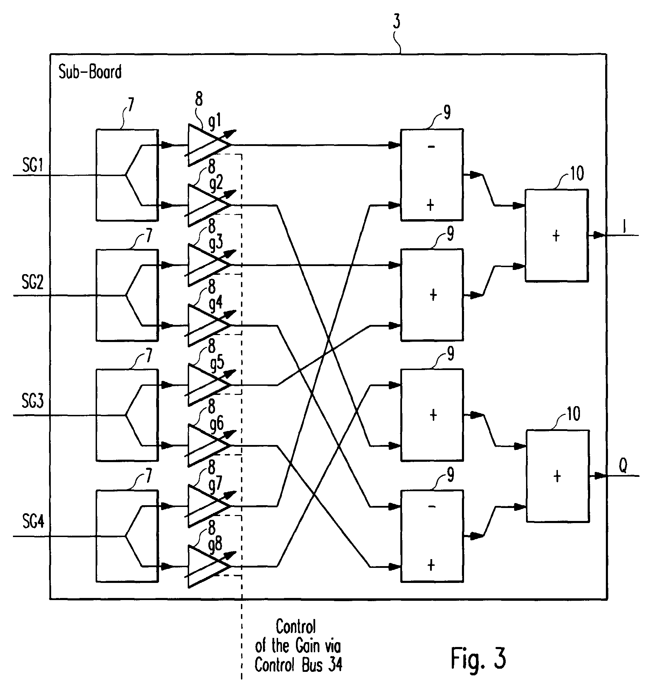

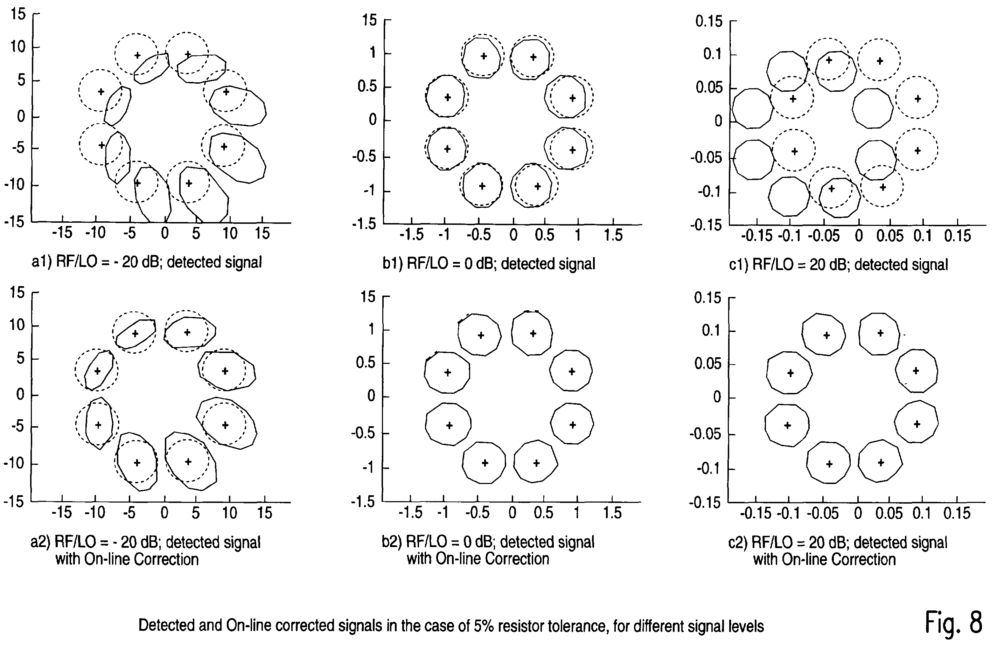

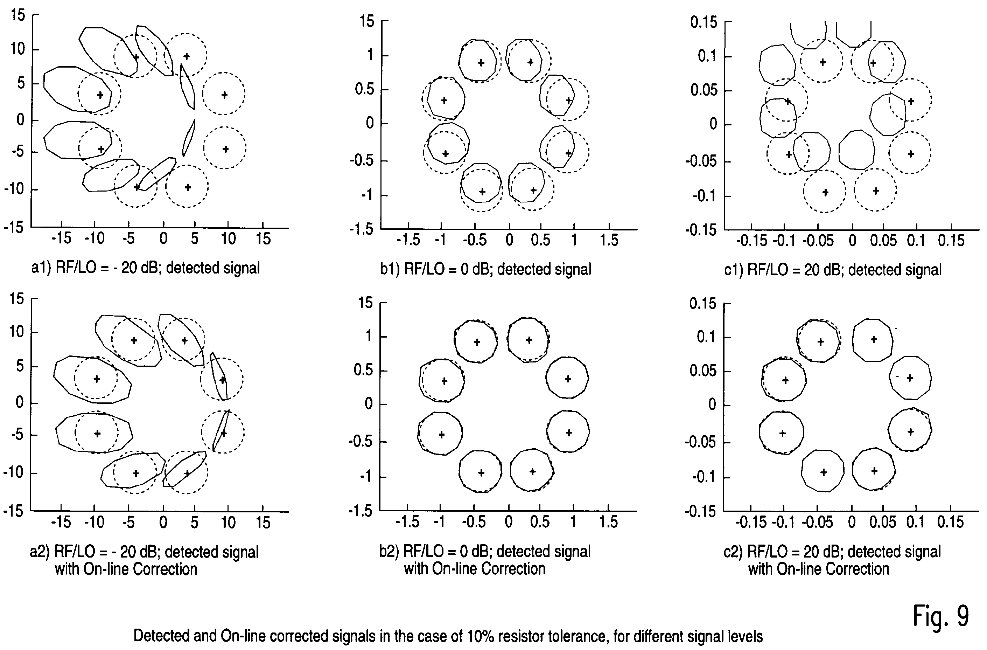

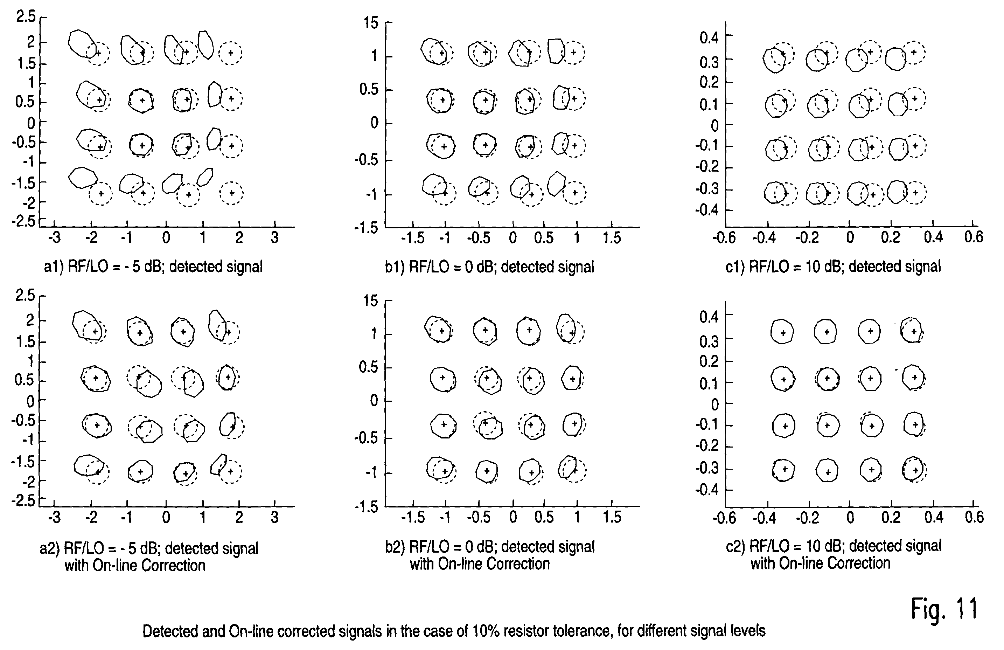

From the European Patent Application 97 122 438.1 in the name of the same applicant a six-port junction device is known. The attention is thereby particularly drawn to figures 3 to 13 and the corresponding pages of the description disclosing implementations of a six-port junction device. The disclosure of the cited pages and figures is also incorporated herewith by reference.

The six-port receiver technology can be implemented by purely passive components. However, the connected demodulators usually comprise active/digital components which are hard not easy to be integrated.

It is the object of the present invention to provide an I/Q demodulation technique for the n-port technology, wherein the technique should be compatible with high integration.

This object is achieved by means of the features of the independent claims. The dependent claims develop further the central idea of the invention.

According to the invention, a I/Q-demodulator connected to a n-port junction device (receiver) comprises only analog circuits.

According to the present invention therefore a method for the I/Q demodulation of modulated RF signals is provided. Thereby the RF signal to be demodulated is input to a passive n-port junction device, n being an integer larger than 3. For example, n can be equal to five or six (five-port junction device and six-port junction device, respectively). A second RF signal is input to the passive n-port junction device. A plurality of analog signals is evaluated by means of said passive n-port junction device and supplied to power detectors. The output signals of the power detectors (power sensors) are supplied to an analog circuitry. The I/Q components of the RF signal to be demodulated are detected based on an analog processing of the signals output of the power detectors by means of the analog circuitry.

The second signal can be supplied by a local oscillator circuitry.

The analog signals output of the power detectors can be filtered before being supplied to the analog circuitry.

Additionally to the analog signals output of the power detectors at least one voltage of one or more DC voltage sources can be supplied to the analog circuitry.

At least one of the signals output of the power detectors can be amplified with an adjustable gain before being supplied to the analog circuitry.

In the analog circuitry the analog signals output of the power detectors can be respectively supplied in at least two branches. Each branch can be amplified with an individually adjustable gain. The amplified branches can be supplied to an adding/subtracting circuitry to detect the I/Q components of the signal to be demodulated.

Furthermore a calibration can be effected by adjusting at least one adjustable gain to compensate for imperfections of the n-port junction device.

Alternatively, in the analog circuitry the analog signals output of the power detectors can be respectively divided in at least two branches and then be supplied to an adding/subtracting circuitry supplying a plurality of output signals. The plurality of output signals of said adding/subtracting circuitry can be amplified with an individually adjustable gain. The amplified output signals can then be supplied to an adding circuitry to detect the I/Q components of the RF signal to be demodulated.

The step of calibrating the demodulation process can be effected by adjusting at least one adjustable gain to compensate for imperfections of the n-port junction device.

The step of calibrating the demodulation can comprise the steps of feeding a predefined sequence as a first signal to the n-port junction device and evaluating and adjusting the gains based on a comparison between the predefined sequence and the actual detected signals.

The step of calibrating the demodulation alternatively can comprise the steps of feeding a predefined sequence as a first signal to the n-port junction device, A/D converting the signals output of the power detectors and evaluating and adjusting the gains based on a comparison between the predefined sequence and the detected and converted signals output of the power detectors.

According to the present invention furthermore an I/Q demodulator is provided. The demodulator thereby can comprise a passive n-port junction device, n being an integer larger than 3 (preferably 4, 5 or 6), wherein a first signal to be demodulated and a second signal is supplied to the passive n-port junction device. A plurality of power detectors can be provided for the detection of signals output of the power detectors.

The n-port junction device can be a four-port junction device, in which case two adjustable DC voltage sources are provided to supply DC voltages to the analog circuitry additionally to the signals output of the power detectors.

An analog circuitry can be provided being supplied with signals output of the power detectors. The analog circuitry detects I/Q components of the signal to be demodulated based on an analog processing of the analog signals output of the power detectors.

A local oscillator circuitry can be provided to supply the second signal.

Filters can be provided for filtering the analog signals output of the power detectors before they are supplied to the analog circuitry.

An adjustable DC voltage source can be provided to supply additionally to the analog signals output of the power detectors a DC voltage to the analog circuitry.

At least one amplifier with adjustable gain can be provided to amplify the signals output of the power detectors before being supplied to the analog circuitry.

The analog circuitry can comprise dividers to divide the analog signals output of the power detectors respectively in at least two branches. An amplifier with an individually adjustable gain can be provided to amplify the branches. An adding/subtracting circuitry can be provided being supplied with the individually amplified branches to detect I/Q components of the signal to be demodulated.

A processing unit can be provided for calibrating the n-port junction device by adjusting at least one adjustable gain.

The analog circuitry can comprise dividers to divide the analog signals output of the power detectors respectively into at least two branches. An adding/subtracting circuitry can be provided being supplied to the branches. An amplifier with an individually adjustable gain can amplify output signals of said adding/subtracting circuitry. An adding circuitry can be supplied with the amplified output signals of said first adding/subtracting circuitry to detect the I/Q components of the signal to be demodulated.

A processing unit for calibrating demodulator (particularly the n-port junction device) by adjusting at least one adjustable gain of the amplifiers with adjustable gain can be provided, wherein the calibration is effected based on a comparison of a known sequence fed to the n-port junction device and actually detected signals.

A digital processing unit can be provided for calibrating the n-port junction device by adjusting at least one adjustable gain of the amplifiers with adjustable gain based on a comparison of a known sequence fed to the n-port junction device and digital signals from A/D converters being supplied to the analog signals output of the power detectors.

The processing unit can be provided on the same board as the n-port junction device and the analog circuitry.

The processing unit can be provided externally to the chip implementing the n-port junction device and the analog circuitry. The calibration thereby can be effected when fabricating the demodulator by connecting the A/D converters to control pins of the demodulator and simultaneously feeding the predefined sequence to the input of the n-port junction device.

According to the present invention furthermore a mobile communications device comprising a demodulator as set forth above is provided.

Further advantages, features and objects of the present invention will come clear from the following detailed description of embodiments of the present invention taken in conjunction with the accompanying drawings:

Figure 1 shows a general view of a receiver comprising an I/Q demodulator according to the present invention

Figure 2 shows the internal structure of the analog circuit board,

Figure 3 shows the internal structure of an embodiment of the subboard comprised in the analog circuit board shown in Figure 2,

Figure 4 shows the internal structure of another embodiment of a simplified subboard comprised in the analog circuit board shown in Figure 2, for the case that a phase shifter a five-port structure provides for a phase shift of 45 degrees,

Figure 5 shows a possible implementation of the present invention by means of a five-port junction device,

Figure 6a, 6b show further embodiments of possible implementations of five-port junction device with an additional isolation function,

Figure 7 shows in a view similar to figure 1 a receiver comprising an I/Q demodulator according to the present invention in combination with a calibration hardware,

Figures 8 to 11 show simulation results of the present invention,

Figure 12 shows the internal structure of an possible implementation of the local oscillator circuitry, and

Figure 13 shows the internal structure of the realization of a power detector.

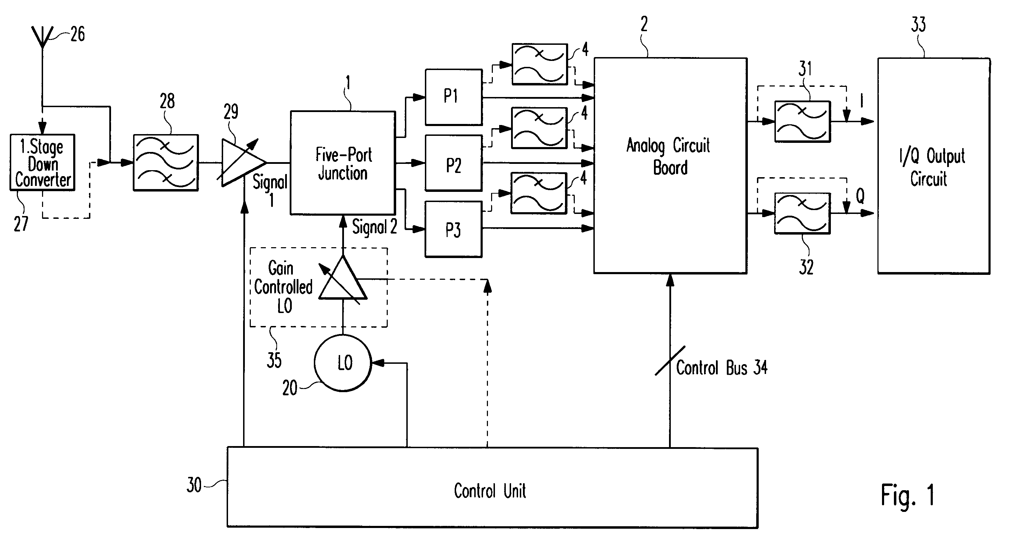

At first an I/Q demodulator according to the present invention will be explained with reference to figure 1.

A modulated RF signal is received by means of an antenna 26. As an example, the received RF signal can be (m)PSK- or (n)QAM, preferably QPSK modulated. The received signal can be passed through a first down converting stage 27. However, it is to be noted that said first down converting stage 27 is only optional. Then the signal is passed through a band pass filter (BPF) 28 and supplied to a gain controlled LNA (low noise amplifier) 29. The gain of the LNA 29 is controlled by a control unit 30. The output signal of the LNA 29 (signal 1) is fed to a first input of a five-port junction device 1. The second input of the five-port junction device 1 is supplied with a gain controlled local oscillator 20, 35, wherein the control unit 30 effects a frequency/phase control to the local oscillator 20. The gain controlled output signal of the local oscillator 20, 35 is supplied as signal 2 to the second input of the five-port junction device 1.

In the embodiment of Figure 1 a five-port junction device is used. However, the present invention is generally applicable to n-port junction devices, as for example six-port-junction devices etc.

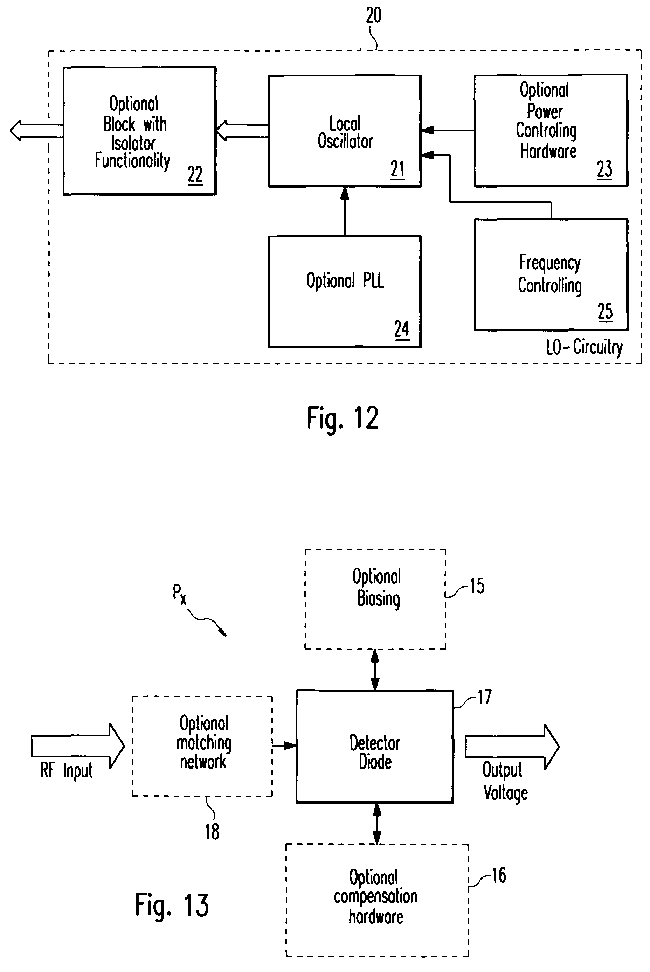

The five-port junction device 1 combines the two input signals signal 1, signal 2 in linear combinations and outputs three signals, wherein the analog power values of the output signals of the five-port junction device 1 are detected by power detectors P1, P2 and P3. The internal structure of the power detectors P1, P2 and P3 will be explained later on with reference to Figure 13. The internal structure of the local oscillator circuitry 20 will be explained later on with reference to Figure 12. The output signals of the power detectors P1, P2, P3 can be optionally low pass filtered 4.

Alternatively, the output signals of the power detectors P1, P2 and P3 can be input directly to an analog circuit board 2. The analog circuit board 2 is connected to the control unit 30 by means of a control bus 34. The analog circuit board provides for two output signals, wherein one of the output signals presents the I-component of the received modulated RF signal, and the other output signal represents the Q-component of the received modulated RF signal. The output signals of the analog circuit board 2 can be optionally low pass filtered 31 before they are supplied to a I/Q-output circuit 33. In the I/Q output circuit 33, for example, an A/D conversion of the input I and Q components can be effected.

The gain control 35 for the local oscillator circuitry is optional.

The control bus 34 transmits control signals for the gain of DC amplifiers and for the control of an adjustable DC voltage source comprised in the analog circuit board 2 which will be explained later on in detail. It is to be noted that the control bus 34 is also optional.

It is to be noted that the I/Q demodulation according to the present invention is effected in a purely analog manner.

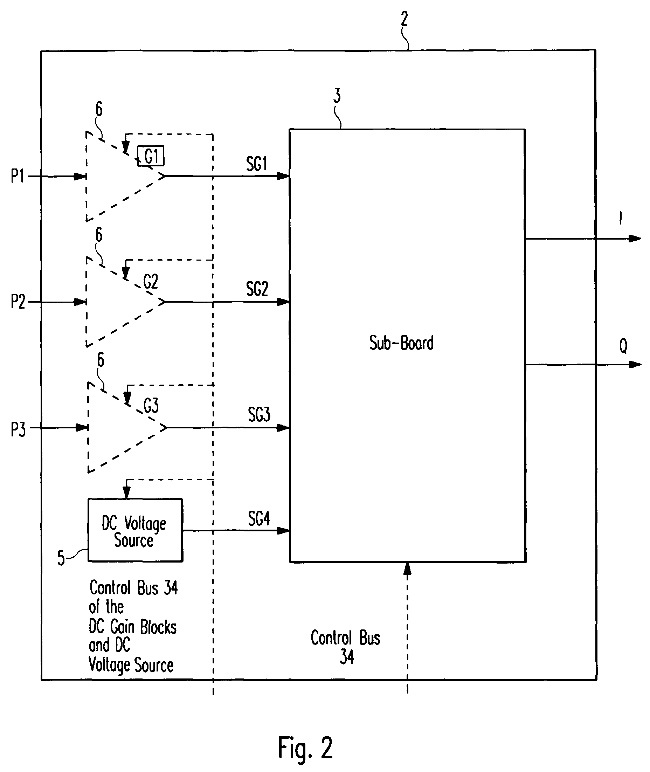

Figure 2 shows the internal structure of the analog circuit board 2. The output signals of the power detectors P1, P2, P3, which can be optionally filtered 4, are respectively input to an amplifier 6 with adjustable gain G1, G2, G3. The gain of the amplifiers 6 with adjustable gain thereby can be optionally controlled by the control bus 34 being connected to the control unit 30. Furthermore, an adjustable DC voltage source 5 is provided, which is also controlled by means of the control bus 34 connected to the control unit 30. The output signals of the amplifiers 6 with adjustable gain SG1, SG2 and SG3 as well as the DC voltage SG4 from the DC voltage source 5 are input to a subboard containing analog circuitry 3. The subboard 3 can also be controlled by means of the control bus 34 connected to the control unit 30. The subboard 3 outputs the I/Q components of the received modulated RF signals. It is to be noted that the amplifiers 6 with adjustable gain are optional and are preferably DC amplifiers capable to cope with the nominal channel bandwidth to be received.

Figure 3 shows the internal structure of the subboard 3 comprised in the analog circuit board 2. The input signals SG1, SG2, SG3 and SG4 are respectively divided in at least two branches respectively by means of functional dividers 7. Optionally each of the branches is then individually amplified by a DC amplifier 8, wherein the gain g1, g2, g3, g4, g5, g6, g7, g8 can also be controlled by the control unit 30 by means of the control bus 34. The amplified branch signals are then supplied in a matrix manner to a subtracting/adding circuitry 9, wherein respectively two output signals of the adding/subtracting circuits 9 are supplied to an adding circuit 10. One of the adding circuits 10 outputs the I component and the other one of the adding circuits 10 outputs the Q component of the thus demodulated RF signal.

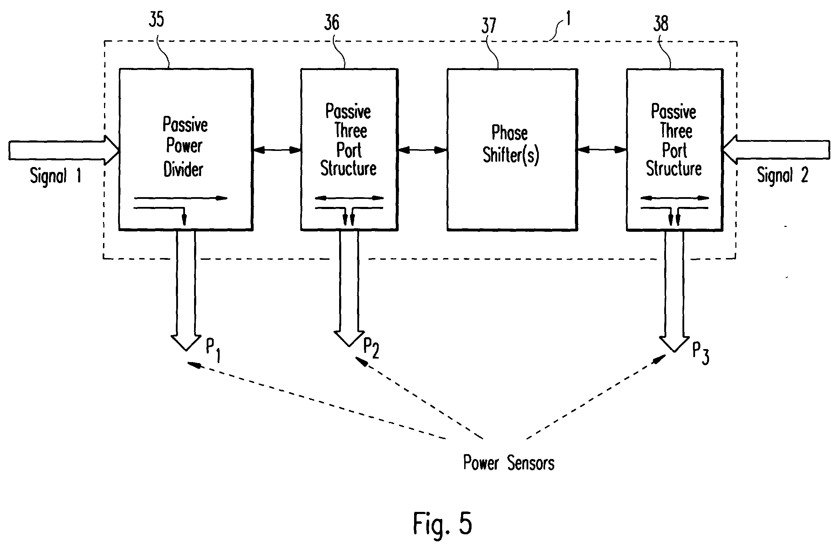

Figure 5 shows a first embodiment of the internal structure of a five-port junction device 1. The signal 1 and signal 2 as shown in Figure 1 are input to the five-port junction device 1. The signal 1 thereby is supplied to a passive power divider 35 being connected with a passive three-port structure 36 and outputting a first power level P1. The passive three-port structure 36 also outputs an analog power value P2 and is furthermore connected with the phase shifters 37. The phase shifter 37 is interconnected between the passive three-port structure 36 and the further passive three-port structure 38 being supplied with the second signal (signal 2 ) and outputting a third analog power value P3.

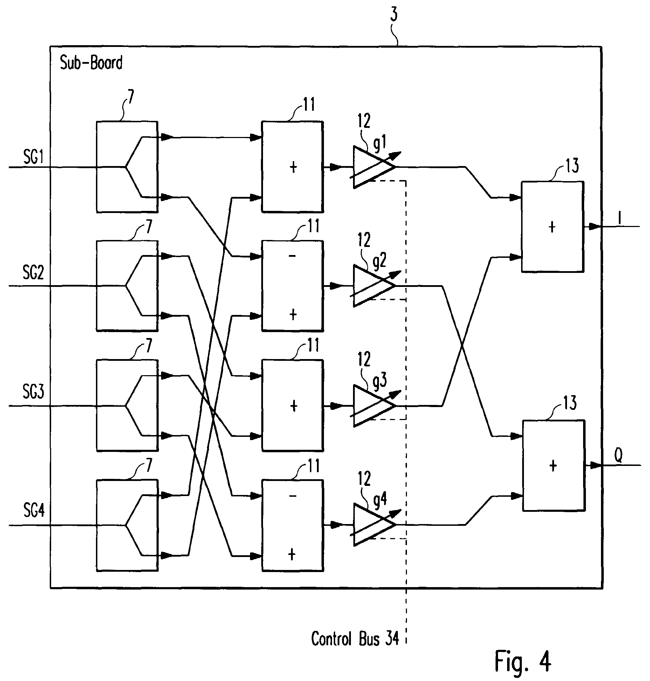

In case a five-port junction 1 with the internal structure as shown in Figure 5 is used, the structure of the subboard 3 as shown in Figure 4 is preferable. As shown in Figure 4, the four signals SG1, SG2, SG3 and SG4 are divided respectively into at least two branches (two in the case shown) by dividers 7. The branches output by the dividers 7 are given to adding/subtracting circuits 11. The adding/subtracting circuits 11 output signals, which are individually amplified by amplifiers 12 with adjustable gain g1, g2, g3, g4, wherein the gains can be individually controlled by the control bus 34 connected to the control unit 30. The amplified output signals are given to two adding circuits 13, wherein one of the adding circuits 13 outputs the I component and the other one of the adding circuits 13 outputs the Q component of the received modulated RF signal.

Considering the topology example of the Fig. 5 we can consider following relation in the case when *S1* presents the modulation of the *RF* signal and Signal *S2* presents the complex value of the *LO* oscillator (In the following equations a reference phase of LO is considered to be zero).

$$s_1 = S_0 d e^{j\varphi} \qquad (1)$$

$$s_2 = S_0 \qquad (2)$$

The I/Q demodulator actually detects the complex ratio of the signals $S1$ and $S2$, or relative amplitude and phase related to the local oscillator. The amplitude ratio is $d$ and $\varphi$ presents phase difference.

$$s = \frac{s_1}{s_2} = de^{j\varphi} \qquad I = d\,\cos\varphi \qquad Q = d\,\sin\varphi \tag{3}$$

The topology of the Fig.3 results in the following complex values ($v1$, $v2$, and $v3$) which are approaching the power sensors. Coefficients $K_{mw}$ are representing transfer functions from port $n$ to the power sensor port $m$.

$$v_1 = k_{11}s_1, \; k_{12} = 0 \tag{4}$$

$$v_2 = k_{21}s_1 + k_{22}e^{-j\theta}s_2 \tag{5}$$

$$v_3 = k_{31}e^{-j\theta}s_1 + k_{32}s_2 \tag{6}$$

$$v_1 = k_{11}S_0 de^{j\varphi} \tag{7}$$

$$v_2 = k_{21}S_0 de^{j\varphi} + k_{22}S_0 e^{-j\theta} \tag{8}$$

$$v_3 = k_{31}S_0 de^{j(\varphi-\theta)} + k_{32}S_0 \tag{9}$$

We are assuming that signal $S2$ has a constant value, meaning for example that the $LO$ does not change its signal power level. In that case we can introduce the new variable $Vdc,$ like in (10).

$$V_{DC} = C|s_2|^2 = CS_0^2 \text{ - set DC voltage} \tag{10}$$

$$P_1 = C|v_1|^2 = Ck_{11}^2 S_0^2 d^2 \tag{11}$$

$$P_2 = C|v_2|^2 = CS_0^2 [k_{21}^2 d^2 + k_{22}^2 + 2k_{21}k_{22}d\,\cos(\varphi+\theta)] \tag{12}$$

$$P_3 = C|v_3|^2 = CS_0^2 [k_{31}^2 d^2 + k_{32}^2 + 2k_{31}k_{32}d\,\cos(\varphi-\theta)] \tag{13}$$

P1, P2 and P3 are low frequency (quasi DC voltages) which exist after power detection by ideal diodes (see figure 13). The value of $\Theta$ corresponds to the phase shift value form the Fig. 5.

$$P_2 = \frac{k_{21}^2}{k_{11}^2} P_1 + k_{22}^2 V_{DC} + 2k_{21}k_{22}V_{DC}d\,\cos(\varphi + \theta) \tag{14}$$

$$P_3 = \frac{k_{31}^2}{k_{11}^2} P_1 + k_{32}^2 V_{DC} + 2k_{31}k_{32}V_{DC}d\,\cos(\varphi-\theta) \tag{15}$$

Implementing equation (3) we can obtain the final equations (16) and (17).

$$I = -\frac{k_{21}k_{32} + k_{22}k_{31}}{4k_{21}k_{31}\cos\theta} - \frac{k_{21}k_{32} + k_{22}k_{31}}{4k_{11}^2 k_{22}k_{32}V_{DC}\cos\theta} P_1 + \frac{1}{4k_{21}k_{22}V_{DC}\cos\theta} P_2 + \frac{1}{4k_{31}k_{32}V_{DC}\cos\theta} P_3 \tag{16}$$

$$Q = -\frac{k_{21}k_{32} - k_{22}k_{31}}{4k_{21}k_{31}\sin\theta} + \frac{k_{21}k_{32} - k_{22}k_{31}}{4k_{11}^2 k_{22}k_{32}V_{DC}\sin\theta} P_1 - \frac{1}{4k_{21}k_{22}V_{DC}\sin\theta} P_2 + \frac{1}{4k_{31}k_{32}V_{DC}\sin\theta} P_3 \tag{17}$$

In the special case, when the phase shift is 45° for:

$$\theta = 45°; \ k_{11} = \frac{1}{2}, \ k_{12} = 0; \ k_{21} = \frac{1}{4}, \ k_{22} = \frac{1}{4}; \ k_{31} = \frac{1}{8}, \ k_{32} = \frac{1}{2}$$

we can obtain a simplified equations for I an Q outputs (18) and (19)

$$I = -\frac{5\sqrt{2}}{4V_{DC}}(V_{DC} + P_1) + \frac{4\sqrt{2}}{V_{DC}}(P_2 + P_3) \qquad (18)$$

$$Q = -\frac{3\sqrt{2}}{4V_{DC}}(V_{DC} - P_1) + \frac{4\sqrt{2}}{V_{DC}}(P_2 - P_3) \qquad (19)$$

As a result of application we can obtain an simplified analog structure like in Fig. 4, which has an reduced number of analog functional components.

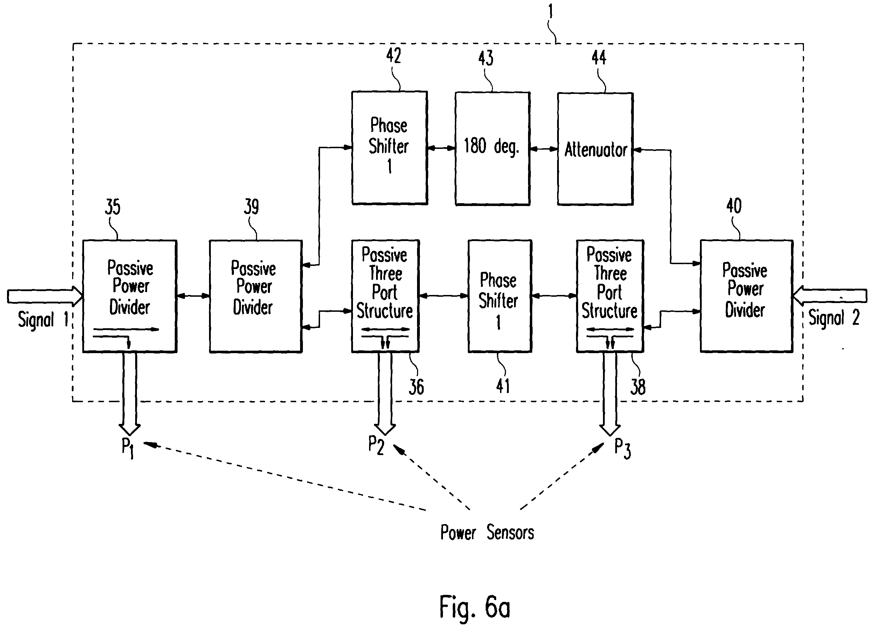

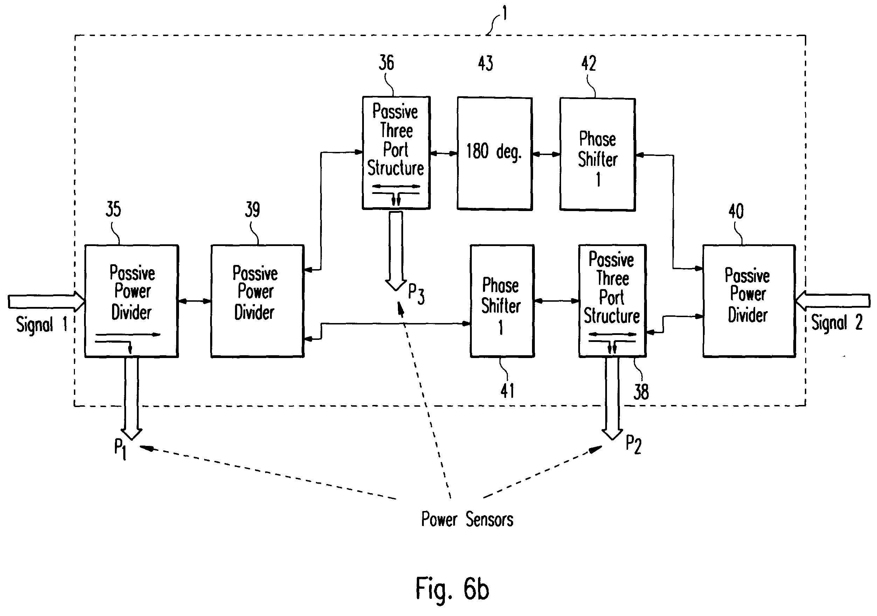

With reference to Figures 6a and 6b further developments of the embodiment as shown in Fig. 5 will now be explained, which provided for an additional RF-LO isolation.

As can be seen from Fig. 6a, according to this embodiment a further passive power divider 39 is connected between the first passive power divider 35 and the passive three-port structure 36. The passive power divider 39 is connected by means of a second phase shifter 42 and an attenuator 44 with a power divider 40. The second phase shifter 42 can provide for a phase shift of 180 degrees. In comparison to the embodiment according to Fig. 5 therefore two passive power dividers 39, 40, a phase shifter 42 and the attenuator 44 have been added. The first phase shifter 41 can also provide for a phase shift of 180 degrees.

Fig. 6b shows another embodiment according to which the passive three-port structure 36 is interconnected between the passive power divider 39 and the phase shifter 42. In this case the attenuator 44 can be omitted.

The embodiments according to Figures 6a and 6b provide for an isolation of the RF-signal port and the local oscillator port.

The embodiment of the subboard according to Figure 4 is particularly preferable for a five-port junction structure as shown in Figure 5, when the phase shift provided by the phase shifter 37 is 45 degrees and the resistive passive power dividers 35 provide for division of 6dB.

The invention can be used at higher frequency and can be adapted to work in a wide band frequency range. Furthermore requirements on RF filtering can be reduced.

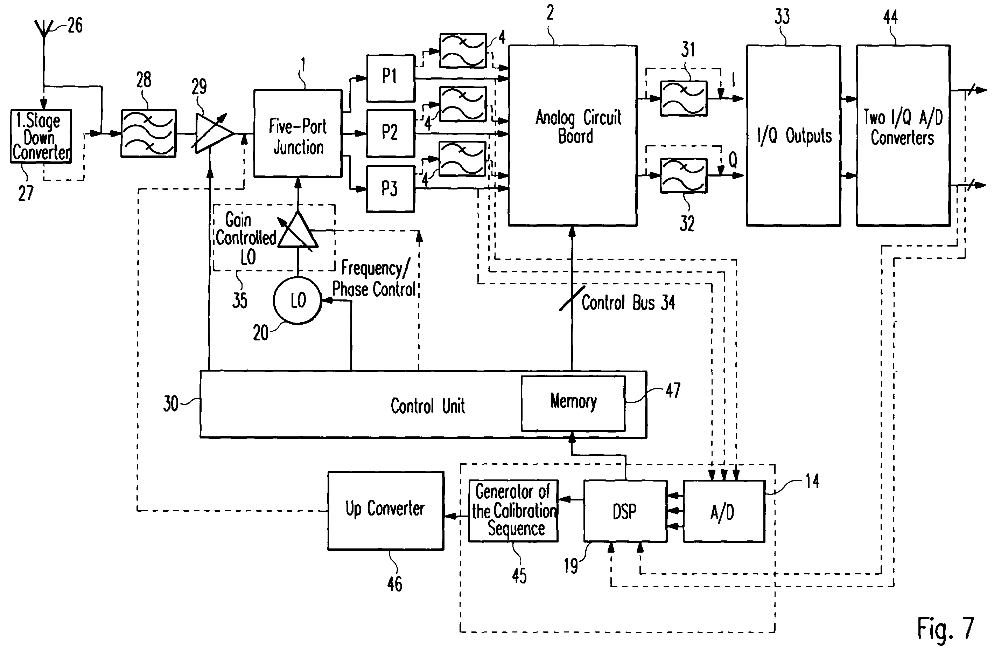

Figure 7 shows an arrangement for calibrating an I/Q demodulator according to the present invention. Thereby a predefined calibration sequence is generated 45. The predefined calibration sequence is up-converted 46 and fed to one input of the five-port junction device 1 (instead of a received signal during the calibration procedure).

According to the first embodiment a digital signal processing unit 19 compares the predefined calibration sequence with the actual detected I/Q components to evaluate the gains of the amplifiers necessary to compensate for imperfections particularly of the five-port junction device 1. The evaluated values for the gains of the amplifiers can be stored in a memory 47 of the control unit once the calibration has been effected.

The up-converter 46 converts the generated predefined calibration sequence to the frequency which is expected to be received by the antenna 26. The upconverter block 46 can be part of the transceiver containing the I/Q demodulator according to the present invention.

According to the first embodiment the digital signal processing unit 19 and the calibration sequence generator 45 can be an internal block attached to the I/Q demodulator (placed on the same chip as the analog circuit board 2 and the five-port junction device 1).

As it is shown with interrupted lines in Figure 7, according to the second embodiment of the invention for calibrating the I/Q demodulator according to the present invention, the analog output signals of the power detectors P1, P2, P3 can be A/D converted by A/D converter 14 and digitized signals of the A/D converters 14 can be input to the DSP 19 for the calculation of the calibration gains. The A/D converters 14 preferably have a high resolution (at least twelve bits), but need not to be very fast. According to this embodiment the A/D converters 14, the DSP unit 19 and the calibration sequence generator 45 can be an external block to be attached only once when manufacturing the I/Q demodulator. In this case when manufacturing the I/Q demodulator, the A/D converters 14 are attached to control pins of the I/Q demodulator (not shown) and simultaneously the calibration signal containing the predefined calibration sequence is fed to an input of the five-port junction device 1.

The second embodiment of the calibration technique is advantageous in case the modulation method which will be used for the received signal (antenna 26) is not known in advance.

If however, the modulation has known states as it is the case for (m)PSK, (n)QAM and preferably when QPSK is used and the channel does not change fast, the first embodiment is to be preferred.

Downwards of the I/Q output circuit 33 additional DC amplifiers can be provided. Furthermore an additional network can be used downwardly of the I/Q output circuit 33 prefect an analog processing calculation of the magnitude and the phase of the signal on the basis of the I and Q outputs.

If the technique according to the present invention is to be used as a five-port direct receiver usually one of the ports where the RF-signals are fed into the circuitry (see Fig. 1) is fed by a local oscillator (LO) circuitry as referenced with 20 in Fig. 12. The LO-circuitry 20 comprises a local oscillator 21 and optionally a power controlling hardware block 23, a PLL block 24, a frequency controlling block 25 and a block 22 having an isolator function as shown in Fig. 12.

In Fig. 13 the internal structure of a power sensor $P_x$ ($0 < x < 4$; x being an integer) is shown. A power sensor $P_x$ essentially comprises at least one detector diode 17, an optional matching network 18, an optional biasing element 15, and an optional compensation hardware 16 providing for a temperature compensation of the diode characteristic. The optional matching network 18 is preferably realized by frequency independent elements (preferably using resistive elements) and is responsible to transform the power sensor input impedance to the same value as the characteristic impedance of the system (usually 50 Ohms or 75 Ohms). The biasing elements 15 give the possibility to increase the sensitivity of the detector diode 17 when applied according to the technology of the used diode process, and external system requirements. The optional compensation hardware 16 can automatically modify the information of the detected power (usually D/C-voltage) in order to minimize the temperature influences or diode non-linearity if a detected signal exceeds a previously assigned voltage border.

The five-port junction device 1 including the power detectors can be realized, for example, by MMIC technology.

The analog circuitry as shown, for example, in Figure 1 can be realized on one chip.

### Simulation Results

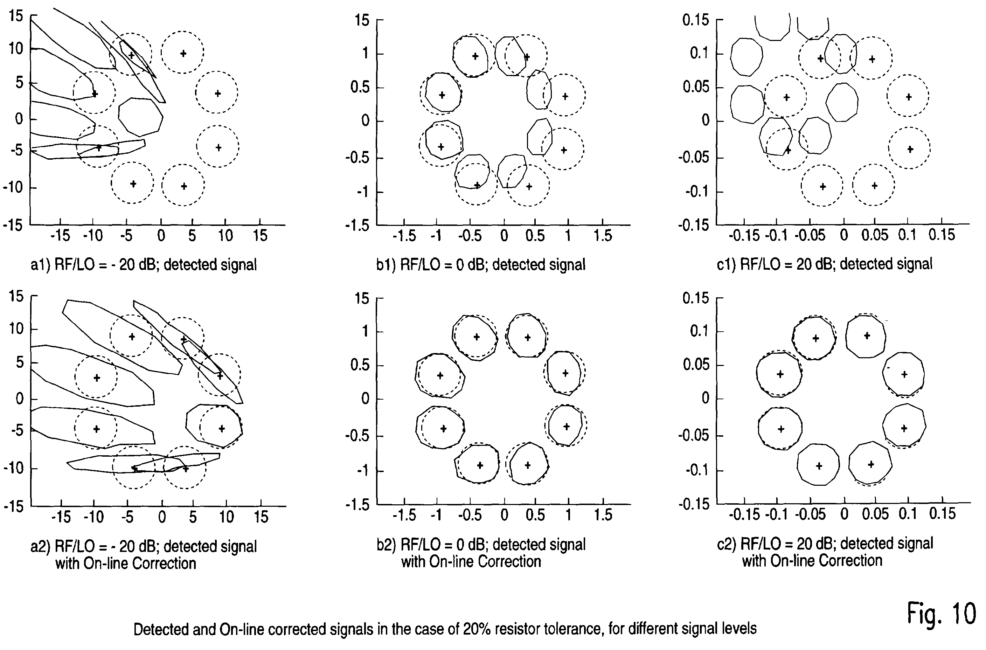

Simulation results are presented for three cases for three different resistor tolerance values: 5%, 10%, 20%, with random distribution, including case when front LNA with gain Control does not manage to adapt the value of the input signal to the LO power. In that case the power Signal amplitude levels of +/- 20 dB appear. This also corresponds to the case when signal with large dynamic range approaches the proposed I/Q demodulator. All of the figures shows the values which should be detected in the case of the 8PSK modulation, as well as really detected values. The case with "on-line" calibration is also shown being preferred when the outputs I/Q values are known and used for calculation of the gain. In the case of exact calibration detected power values are known, by taking the information from the control points at the output side of the power detectors. This is done by additional high resolution (but inherently slow) three A/D converters, which can be placed on the same board or can be only once in the process of manufacturing of the device connected to the control points of the proposed I/Q demodulator. In that case one obtains a perfect value identical as expected so that pictures are not shown on the diagrams. In all 8PSK cases a noise margin of 20dB is included. In the Figure 10 examples considering 16 QAM, with a signal strength deviation from -5 to + 10 dB relative to the LO is presented. Note that only two points (despite 16 modulation states) are used for linear "on-line" correction of the signals.

Analyzing simulation results it can be stated that if a resistor topology for five-port junction is utilized it is highly recommended to have resistors with smaller tolerances.

Following the shown simulation results the following conditions are satisfied:

- a simple modulation technique is used with inherently low dynamic range of the modulation states,
- resistors tolerances have tolerance margins better than 10%,
- AGC or gain control LNA can translate RF signal with +/- 10 dB in respect to the mean power
- if a AGC or gain control is set that RF signal is in region lower than strength of the LO signal

A rigorous (Ideal) calibration can be possibly omitted. An additional reference point can be used for linear transformation of the data, if there is no fast change of the channel.

In cases when the number of the modulation states are known and if the channel does not change to fast, a post correction can be done. For that purpose a polynomial transformation is proposed, when all of the states has to be sent in the similar manner as a training sequence.

Finally a rigorous calibration can be performed in the process of manufacturing. In that case gain levels for the has to be calculated after evaluating power sensor outputs, sent calibration sequence and I/Q outputs. The resulted gain values are then memorized in the memory and used in the normal working process of the proposed I/Q demodulator.

### Claims

1. Method for the I/Q demodulation of modulated RF signals,

comprising the following steps:

- inputting the RF signal to be demodulated (signal 1) to a passive n-port junction device (1), n being an integer larger than 3,
- inputting a second RF signal (signal 2) to said passive n-port junction device (1),
- evaluating a plurality of analog signals by means of said passive n-port junction device (1) and supplying the analog signals to power detectors,
- supplying output signals of the power detectors to an analog circuitry (2, 3),
- detecting the I/Q components of the signal to be demodulated (signal 1) based on an analog processing of the analog signals by means of the analog circuitry (2, 3).

2. Method according to claim 1,
characterized in that
three analog signals are detected by means of a five-port junction device (1) and three output signals of power detectors are supplied to said analog circuitry (2, 3).

3. Method according to claim 1,
characterized in that
two analog signals are detected by means of a four-port junction device (1) and two output signals of power detectors are supplied to said analog circuitry (2, 3).

4. Method according to anyone of the preceding claims,
characterized in that
the second signal (signal 2) is supplied by a local oscillator circuitry (20).

5. Method according to anyone of the preceding claims,
characterized in that
the output signals of the power detectors are filtered (4) before being supplied to the analog circuitry (2, 3).

6. Method according to anyone of the preceding claims,
characterized in that
additionally to the output signals of the power detectors, at least one adjustable DC voltage (5) is supplied to the analog circuitry (2, 3).

7. Method according to anyone of the preceding claims,
characterized in that
at least one of output signals of the power detectors is amplified with an adjustable gain (G1, G2, G3) before being supplied to the analog circuitry (3).

8. Method according to anyone of the preceding claims,
characterized in that
in the analog circuitry (3)

- the output signals of the power detectors are respectively supplied (7) in at least two branches,
- each branch is amplified (8) with an individually adjustable gain (g1, g2, g3, g4, g5, g6, g7, g8), and
- the amplified branches are supplied to an adding/subtracting circuitry (9, 10) to detect the I/Q components of the signal to be demodulated (signal 1).

9. Method according to claim 8,
characterized by
the step of calibrating the I/Q demodulation by adjusting at least one adjustable gain (g1, g2, g3, g4, g5, g6, g7, g8) to compensate for imperfections of the n-port-junction device (1).

10. Method according to anyone of claims 1 to 9,
characterized in that
in the analog circuitry (3)

- the analog signals are respectively supplied (7) in at least two branches,

- the branches are supplied to an adding/subtracting circuitry (11) supplying a plurality of output signals,
- the plurality of output signals of said adding/subtracting circuitry (11) is amplified (12) with an individually adjustable gain (g1, g2, g3, g4), and
- the amplified output signals of said first adding/subtracting circuitry (11) are supplied to an adding circuitry (13)

to detect the I/Q components of the signal to be demodulated (signal 1).

11. Method according to claim 10,
characterized by
the step of calibrating the I/Q demodulation by adjusting at least one adjustable gain (g1, g2, g3, g4) to compensate for imperfections of the n-port-junction device (1).

12. Method according to anyone of the preceding claims,
characterized by
the step of calibrating the I/Q demodulation by

- feeding a predefined sequence as a first signal (signal 1) to the n-port-junction-device (1), and
- evaluating and adjusting at least one of the gains (g1, g2, g3, g4, g5, g6, g7, g8) based on a comparison (19) between the predefined sequence and the actual detected signals by effecting a complex linear transformation.

13. Method according to anyone of claims 1 to 12,
characterized by
the step of calibrating the I/Q demodulation by

- feeding a predefined sequence as a first signal (signal 1) to the n-port-junction-device (1),
- A/D converting (14) the analog signals, and
- evaluating and adjusting at least one of the gains (g1, g2, g3, g4, g5, g6, g7, g8) based on a comparison (19) between the predefined sequence and the detected converted analog signals.

14. Method according to claim 12,
characterized in that
the calibration is effected by means of an additional calibration hardware being provided on the same chip or board as the n-port junction device (1)

15. Method according to claim 12,
characterized in that
the additional calibration hardware is interfaced with the n-port junction device (1) once when fabricating, wherein the calibration gains (g1, g2, g3, g4, g5, g6, g7, g8; G1, G2, G3, G3) are stored in a memory.

16. I/Q-Demodulator, comprising:

- a passive n-port junction device (1), n being an integer larger than 3, a first RF signal to be demodulated (signal 1) and a second RF signal (signal 2) being supplied to said passive n-port junction device (1),
- a plurality of power detectors (P1, P2, P3, P(n-2)) being supplied with analog output signals of said passive n-port junction device (1),
- an analog circuitry (2, 3) being supplied with signals output of the power detectors (P1, P2, P3, P(n-2)), wherein the analog circuitry (2, 3) detects I/Q components of the RF signal to be demodulated (signal 1) based on an analog processing of signals output of the power detectors (P1, P2, P3, P(n-2)).

17. I/Q-Demodulator according to claim 16,
characterized in that
three power detectors (P1, P2, P3) are provided.

18. I/Q-Demodulator according to claim 16,
characterized in that
two power detectors are provided

19. I/Q-Demodulator according to claim 16 to 18,

characterized in that
a local oscillator circuitry (20) is provided to supply the second RF signal (signal 2).

**20.** I/Q- Demodulator according to anyone of the claims 16 to 19,
characterized in that
filters (4) are provided for filtering the signals output of the power detectors (P1, P2, P3) before they are supplied
to the analog circuitry (2, 3).

**21.** I/Q-Demodulator according to anyone of claims 16 to 20,
characterized in that
the n-port junction device is a five-port junction device, and
an adjustable DC voltage source (5) is provided to supply a DC voltage (5) to the analog circuitry (2, 3) additionally
to the signals output of the power detectors (P1, P2, P3).

**22.** I/Q-Demodulator according to anyone of claims 16 to 20,
characterized in that
the n-port junction device is a four-port junction device, and
two adjustable DC voltage sources are provided to supply DC voltages (5) to the analog circuitry (2, 3) additionally
to the signals output of the power detectors (P1, P2).

**23.** I/Q-Demodulator according to anyone of claims 16 to 22,
characterized in that
at least one amplifier (6) with adjustable gain (G1, G2, G3, G4) is provided to amplify the signals output of the power
detectors (P1, P2, P3) before being supplied to the analog circuitry (3).

**24.** I/Q-Demodulator to anyone of claims 16 to 23,
characterized in that
the analog circuitry (3) comprises:

- divider (7) to supply the signals output of the power detectors (P1, P2, P3) respectively in at least two
  branches,
- amplifier (8) with individually adjustable gain (g1, g2, g3, g4, g5, g6, g7, g8) to amplify the branches, and
- an adding/subtracting circuitry (9, 10) being supplied with the individually amplified branches,

to detect I/Q components of the signal to be demodulated (signal 1).

**25.** I/Q-Demodulator according to claim 24,
characterized by
a processing unit (19) is provided for calibrating the n-port-junction device (1) by adjusting at least one adjustable
gain (g1, g2, g3, g4, g5, g6, g7, g8).

**26.** I/Q-Demodulator according to anyone of claims 16 to 25,
characterized in that
the analog circuitry (3) comprises

- divider (7) to supply the signals output of the power detectors (P1, P2, P3) respectively in at least two
  branches,
- an adding/subtracting circuitry (11) being supplied with the branches,
- amplifier (12) with individually adjustable gain (g1, g2, g3, g4, g5, g6, g7, g8) for amplifying output signals of
  said adding/subtracting circuitry (11), and
- an adding circuitry (13) being supplied with the amplified output signals of said adding/subtracting circuitry
  (11),

to detect the I/Q components of the signal to be demodulated (signal 1).

**27.** I/Q-Demodulator to claim 26,
characterized by
a processing unit (19) for calibrating the n-port-junction device (1) by adjusting at least one adjustable gain (g1, g2, g3, g4, g5, g6, g7, g8) of the amplifier with adjustable gain based on a comparison of a known sequence fed to the n-port-junction device (1) and actually detected I/Q signal components.

28. I/Q-Demodulator according to claim 26,
characterized by
a digital processing unit (19) for calibrating the n-port-junction device (1) by adjusting at least one adjustable gain (g1, g2, g3, g4) of the amplifier with adjustable gain based on a comparison of a known sequence fed to the n-port-junction device (1), digital signals from A/D converters (14) being supplied with the analog signals output of the power detectors (P1, P2, P3, P(n-2)) and actually detected I/Q signal components.

29. I/Q-Demodulator according to claim 27 or 28,
characterized in that
the processing unit (19) and additional calibration hardware is provided on the same chip or board as the n-port-junction device (1) and the analog circuitry (2, 3).

30. I/Q-Demodulator according to claim 28
characterized in that
the processing unit (19) and additional calibration hardware is provided externally to a chip or board comprising the n-port-junction device (1) and the analog circuitry (2, 3),
wherein the calibration is effected when fabricating the I/Q-demodulator by connecting the A/D converters (14) to control pins of the demodulator and simultaneously feeding the predefined sequence to the input of the n-port-junction-device (1).

31. Communication device,
characterized in that
it comprises a I/Q-demodulator according to anyone of claims 13 to 25.

Fig. 1

EP 0 957 614 A1

Fig. 2

Fig. 3

Fig. 4

Fig. 5

Fig. 6a

EP 0 957 614 A1

Fig. 6b

Fig. 7

EP 0 957 614 A1

a1) RF/LO = - 20 dB; detected signal

b1) RF/LO = 0 dB; detected signal

c1) RF/LO = 20 dB; detected signal

a2) RF/LO = - 20 dB; detected signal
with On-line Correction

b2) RF/LO = 0 dB; detected signal
with On-line Correction

c2) RF/LO = 20 dB; detected signal
with On-line Correction

Detected and On-line corrected signals in the case of 5% resistor tolerance, for different signal levels

Fig. 8

a1) RF/LO = - 20 dB; detected signal

b1) RF/LO = 0 dB; detected signal

c1) RF/LO = 20 dB; detected signal

a2) RF/LO = - 20 dB; detected signal
with On-line Correction

b2) RF/LO = 0 dB; detected signal
with On-line Correction

c2) RF/LO = 20 dB; detected signal
with On-line Correction

Fig. 9

Detected and On-line corrected signals in the case of 10% resistor tolerance, for different signal levels

EP 0 957 614 A1

a1) RF/LO = - 20 dB; detected signal

b1) RF/LO = 0 dB; detected signal

c1) RF/LO = 20 dB; detected signal

a2) RF/LO = - 20 dB; detected signal
with On-line Correction

b2) RF/LO = 0 dB; detected signal
with On-line Correction

c2) RF/LO = 20 dB; detected signal
with On-line Correction

Fig. 10

Detected and On-line corrected signals in the case of 20% resistor tolerance, for different signal levels

a1) RF/LO = - 5 dB; detected signal

a2) RF/LO = - 5 dB; detected signal with On-line Correction

b1) RF/LO = 0 dB; detected signal

b2) RF/LO = 0 dB; detected signal with On-line Correction

c1) RF/LO = 10 dB; detected signal

c2) RF/LO = 10 dB; detected signal with On-line Correction

Detected and On-line corrected signals in the case of 10% resistor tolerance, for different signal levels

Fig. 11

20

| Optional Block with Isolator Functionality 22 | ← | Local Oscillator 21 | ← | Optional Power Controlling Hardware 23 |
| | | ↑ | | Frequency Controlling 25 |
| | | Optional PLL 24 | | |

LO-Circuitry

## Fig. 12

Px

| | Optional Biasing 15 | |
| RF Input → | Optional matching network 18 | → | Detector Diode 17 | → Output Voltage |
| | | Optional compensation hardware 16 | |

## Fig. 13

**European Patent Office**

## EUROPEAN SEARCH REPORT

Application Number

EP 98 10 8833

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X,D | LI ET AL.: "A six-port direct digital millimeter wave receiver" IEEE MTT-S INTERNATIONAL MICROWAVE SYMPOSIUM, 23 - 27 May 1994, pages 1659-1662, XP000512814 New York, US * figure 1 * * page 1660, left-hand column, paragraph 2 - right-hand column, paragraph 1 * --- | 1,4,5,7, 12-16, 19,20,23 | H04L27/227 H04L27/38 |
| X | EP 0 841 756 A (NOKIA MOBILE PHONES) 13 May 1998 * figures 1,3 * * column 1, line 7 - line 15 * * column 4, line 8 - line 12 * --- | 1,4,5,7, 12-16, 19,20,23 | |
| X | EP 0 805 561 A (NOKIA MOBILE PHONES) 5 November 1997 * figures 1,2 * * page 2, line 8 - line 9 * * page 2, line 19 - line 24 * * page 6, line 7 - line 9 * --- | 1,4,5,7, 12-16, 19,20,23 | TECHNICAL FIELDS SEARCHED (Int.Cl.6) H04L |
| X | US 4 163 232 A (FITZSIMMONS) 31 July 1979 * figure * * column 1, line 40 - line 45 * --- | 1,3,4, 16,22 | |
| X | US 4 013 960 A (GODET SIDNEY) 22 March 1977 * figure 4 * ----- | 1,3,4, 16,22 | |

The present search report has been drawn up for all claims

| Place of search | Date of completion of the search | Examiner |
|---|---|---|
| THE HAGUE | 5 October 1998 | Scriven, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document